(19) Europäisches Patentamt
European Patent Office
Office européen des brevets

(11) Publication number : **0 554 101 A1**

(12) # EUROPEAN PATENT APPLICATION

(21) Application number : **93300647.0**

(51) Int. Cl.[5] : **G03F 7/075**

(22) Date of filing : **28.01.93**

(30) Priority : **29.01.92 JP 36986/92**

(43) Date of publication of application :
**04.08.93 Bulletin 93/31**

(84) Designated Contracting States :
**DE FR GB**

(71) Applicant : **JAPAN SYNTHETIC RUBBER CO., LTD.**
**11-24, Tsukiji-2-chome Chuo-ku**
**Tokyo 104 (JP)**

(72) Inventor : **Miyamoto, Hideroshi**
**1-3-201, Morigayama-cho**
**Yokkaichi-shi, Mie-ken 510 (JP)**
Inventor : **Miyashita, Satoshi**
**1-17-203, Morigayama-cho**
**Yokkaichi-shi, Mie-ken 510 (JP)**
Inventor : **Yumoto, Yoshiji**
**3698-1, Uneme-cho**
**Yokkaichi-shi, Mie-ken 510 (JP)**
Inventor : **Miura, Takao**
**2-22-6, Mitakidai**
**Yokkaichi-shi, Mie-ken 510 (JP)**

(74) Representative : **Clifford, Frederick Alan**
**MARKS & CLERK 57/60 Lincoln's Inn Fields**
**London WC2A 3LS (GB)**

(54) **Radiation-sensitive resin composition.**

(57) A radiation-sensitive resin composition containing an alkali-soluble resin, a 1,2-quinonediazide compound and a compound of the formula (1),

$$X\text{-}C_nH_{2n}\text{-}Si(OR)_3 \qquad (1)$$

wherein each of Rs is independently an alkyl group, n is an integer of 1 to 5, and X is

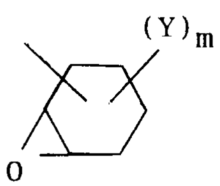

,

in which Y or each of Ys is independently an alkyl or alkoxy group and m is an integer of 0 to 9.

EP 0 554 101 A1

Detailed Description of the Invention

The present invention relates to a radiation-sensitive resin composition. More specifically, it relates to a radiation-sensitive resin composition suitable as a photoresist for producing integrated circuits which responds to radiations such as ultraviolet light, far ultraviolet light, X-ray, electron beam, molecular beam, γ-ray, synchrotron radiation and proton beam or suitable for producing a liquid crystal display element or a liquid crystal display device.

Positive resists are often used for producing integrated circuits, since they give high-resolution resist patterns. In recent years, positive resists have been also being frequently used for producing liquid crystal display elements and liquid crystal display devices. Under the above circumstances, there are strong demands for a positive resist which has high sensitivity and high heat resistance and which shows high acid resistance to etching solutions and high adhesion to substrates when the substrates for producing integrated circuits, liquid crystal display elements and liquid crystal display devices are etched.

It is an object of the present invention to provide a novel radiation-sensitive resin composition.

It is another object of the present invention to provide a radiation-sensitive resin composition suitable as a positive resist, which has high sensitivity, high resolution and high heat resistance and which also has high acid resistance to etching solutions and high adhesion to substrates when the substrates are etched.

Other objects and advantages of the present invention will be apparent from the following description.

According to the present invention, the above objects and advantages are achieved by a radiation-sensitive resin composition containing an alkali-soluble resin, a 1,2-quinonediazide compound and a compound of the formula (1) (to be referred to as "compound (I)" hereinafter),

$$X\text{-}C_nH_{2n}\text{-}Si(OR)_3 \qquad (1)$$

wherein each of Rs is independently an alkyl group, n is an integer of 1 to 5, and X is

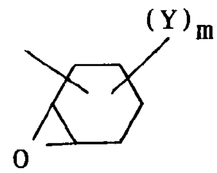

,

in which each of Ys is independently an alkyl or alkoxy group and m is an integer of 0 to 9.

The radiation-sensitive resin composition of the present invention contains a compound of the above formula (1).

In the formula (1), Rs may be the same or different, and each of Rs is an alkyl group, preferably an alkyl group having 1 to 3 carbon atoms. The alkyl group may be linear or branched. Specific examples of the alkyl group include methyl, ethyl, n-propyl and iso-propyl.

X is 1,2-, 2,3- or 3,4-epoxycyclohexyl group which optionally has substituent(s), Y, as defined in the formula (1).

A plurality of the substituents, Y, may be the same or different, and each of Ys is an alkyl or alkoxy group, preferably an alkyl or alkoxy group having 1 to 3 carbon atoms. The alkyl or alkoxy group may be linear or branched. SPecific examples of the alkyl and alkoxy groups include methyl, ethyl, n-propyl, iso-propyl, methoxy, ethoxy, n-propoxy and iso-propoxy.

In the formula (1), n is an integer of 1 to 5, preferably an integer of 1 to 3, and m is an integer of 0 to 9, preferably an integer of 0 to 2.

Examples of the compound (I) preferably include 2-(3,4-epoxycyclohexyl)ethyltrimethoxysilane, 2-(3,4-epoxycyclohexyl)ethyltriethoxysilane, 2-(3,4-epoxycyclohexyl)ethyltripropoxysilane, 2-(3,4-epoxycyclohexyl)ethyldimethoxymonoethoxysilane, 2-(3,4-epoxycyclohexyl)ethylmonomethoxydiethoxysilane, (3,4-epoxycyclohexyl)methyltrimethoxysilane, 3-(3,4-epoxycyclohexyl)propyltrimethoxysilane, 2-(2,3-epoxycyclohexyl)ethyltrimethoxysilane, 2-(1,2-epoxycyclohexyl)ethyltrimethoxysilane, and 2-(2,3-epoxycyclohexyl)ethyltriethoxysilane.

The amount of the compound (I) per 100 parts by weight of the alkali-soluble resin is preferably 0.1 to 25 parts by weight, more preferably 1 to 15 parts by weight. When the amount of the compound (I) is less than 0.1 part by weight, the resultant resin composition is liable to show poor adhesion to substrates such as a glass substrate, a glass substrate coated with indium tin oxide (to be referred to as "ITO substrate" hereinafter), an amorphous Si substrate, a chrome substrate and an aluminum substrate. When the above amount exceeds 25 parts by weight, the resultant resin composition tends to show deteriorated acid resistance to etching solutions such as a hydrochloric acid aqueous solution, a hydrochloric acid-ferric chloride mixed aqueous solution,

a hydrogen fluoride aqueous solution, a nitric acid aqueous solution, a phosphoric acid aqueous solution, a hydrogen fluoride-nitric acid mixed aqueous solution, a phosphoric acid-nitric acid mixed aqueous solution, a hydrogen fluoride-nitric acid-acetic acid mixed aqueous solution and a phosphoric acid-nitric acid-acetic acid mixed aqueous solution.

Examples of the alkali-soluble resin used in the present invention include a novolak resin, an acrylic resin, a copolymer obtained from a polyvinyl alcohol, styrene and acrylic acid, a hydroxystyrene polymer, polyvinylhydroxybenzoate and polyvinylhydroxybenzyl. Of these alkali-soluble resins, preferred is an alkali-soluble novolak resin (to be simply referred to as "resin" hereinafter).

The resin is obtained by polycondensation of a phenol and an aldehyde. The amount of the aldehyde per mole of the phenol is preferably 0.7 to 3 mol, more preferably 0.75 to 1.3 mol.

Acidic catalyst is used for the above polycondensation. Examples of the acidic catalyst include hydrochloric acid, nitric acid, sulfuric acid, formic acid, oxalic acid and acetic acid.

In the above polycondensation, water is generally used as a reaction medium. The amount of the acidic catalyst per mole of the phenol is $1 \times 10^{-5}$ to $5 \times 10^{-1}$ mol. When a hydrophilic solvent is used as the reaction medium, the amount of the acidic catalyst per mole of the phenol is preferably $1 \times 10^{-4}$ to 5 mol.

Examples of the above hydrophilic solvent include alcohols such as methanol, ethanol, propanol and butanol, and cyclic ethers such as tetrahydrofuran and dioxane. The amount of the reaction medium per 100 parts by weight of the raw materials is 20 to 1,000 parts by weight.

The reaction temperature for the polycondensation can be properly adjusted depending upon the reactivity of the raw materials, and it is preferably between 10 and 200°C.

The polycondensation can be carried out, for example, by a method in which phenol and aldehyde are supplementingly added as the reaction between phenol and aldehyde proceeds.

After the polycondensation finishes, unreacted mateiials, the acidic catalyst and the reaction medium which remain in the reaction system are removed, generally, by increasing the internal temperature of the reaction mixture up to 130 to 230°C and distilling off volatiles under reduced pressure, e.g., of approximately 20 to 50 mmHg, and the resin is recovered. Alternatively, after the polycondensation finishes, the reaction mixture is dissolved in a solvent which can dissolve the resin, such as methyl alcohol, ethylcellosolve acetate or dioxane, and a precipitant such as water, n-hexane or n-heptane is added to precipitate the resin. Then, the resin is separated and recovered. Further, for recovering the resin, the resin can be fractionated to a component having a high molecular weight and a component having a low molecular weight by changing the ratio between the solvent and the precipitant, and the so-recovered resin can be used.

Moreover, the resin can be also obtained by the method described in JP-A-2-222409.

Examples of the phenol used for the above polycondensation preferably include m-cresol, p-cresol and a phenol of the following formula (2) (to be referred to as "a phenol A" hereinafter).

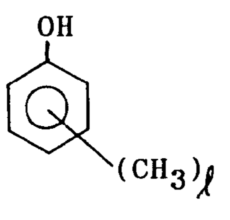

(2)

wherein $\ell$ is 2 or 3.

The above phenol is used singly or in combination, and is used preferably in the m-cresol/p-cresol/phenols A molar ratio of 40-100/0-55/0-60, more preferably 60-100/0-30/0-40.

When the amount of the m-cresol is less than 40 mol%, a composition containing the resultant resin is liable to show poor sensitivity. When the amount of the p-cresol exceeds 55 mol%, a composition containing the resultant resin is liable to show poor sensitivity. When the amount of the phenols A exceeds 60 mol%, a composition containing the resultant resin tends to show poor sensitivity and poor adhesion.

Examples of the above phenols A include 2,3-xylenol, 2,4-xylenol, 2,5-xylenol, 2,6-xylenol, 3,4-xylenol, 3,5-xylenol, 2,3,4-trimethylphenol, 2,3,5-trimethylphenol and 3,4,5-trimethylphenol.

Examples of the aldehyde used for the above polycondensation include formaldehyde, benzaldehyde, furfural and acetaldehyde. Of these aldehydes, formaldehyde is particularly preferred.

The weight average molecular weight (to be referred to as "Mw" hereinafter), as polystyrene, of the resin is preferably 3,000 to 15,000, particularly preferably 4,000 to 12,000. When Mw is less than 3,000, a composition containing the resin is liable to be poor in acid resistance and heat resistance. When it exceeds 15,000, a composition containing the resin is liable to be poor in sensitivity and adhesion.

The dispersion degree of the resin {Mw/number average molecular weight (to be referred to as Mn hereinafter) as polystyrenes is preferably 5 to 20, particularly preferably 8 to 15. When the dispersion degree is less than 5, a composition containing the resin is liable to deteriorate in sensitivity and adhesion. When it exceeds 20, a composition containing the resin is liable to show poor acid resistance.

The 1,2-quinonediazide compound used in the composition of the present invention is a radiation-sensitive compound, and preferably includes esters obtained from hydroxy compounds having at least two benzene skeletons having a hydroxyl group, such as compounds of the following formulae (to be simply referred to as "compounds B" hereinafter),

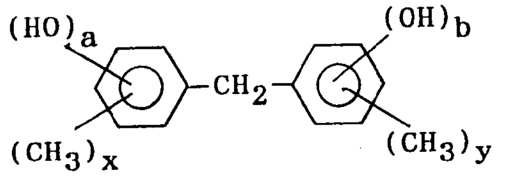
,

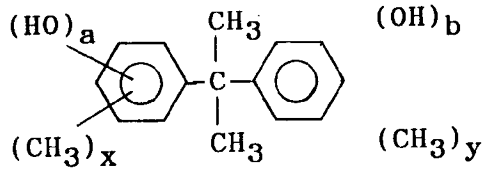
,

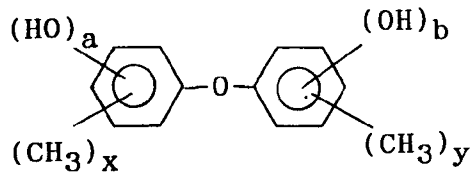
,

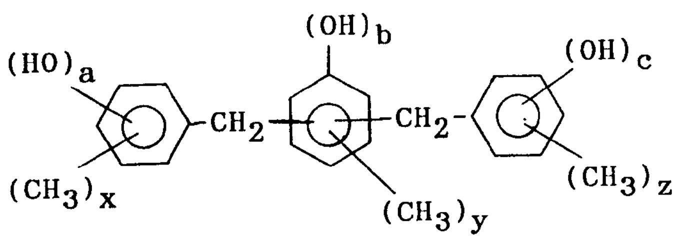
,

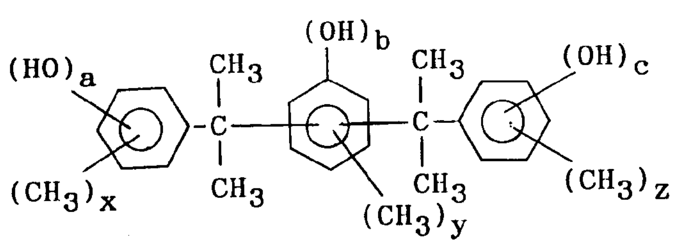
,

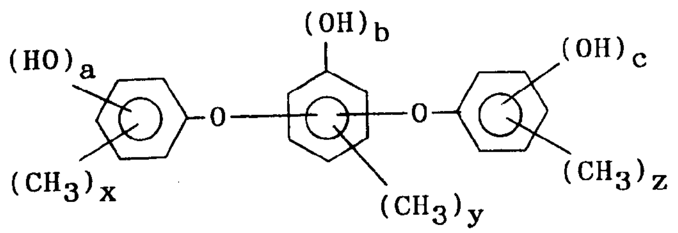

,

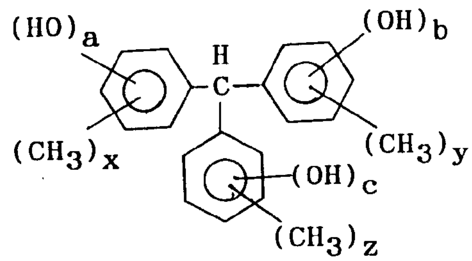

,

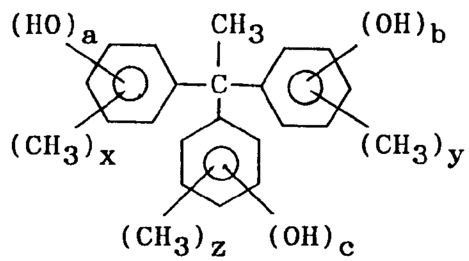

,

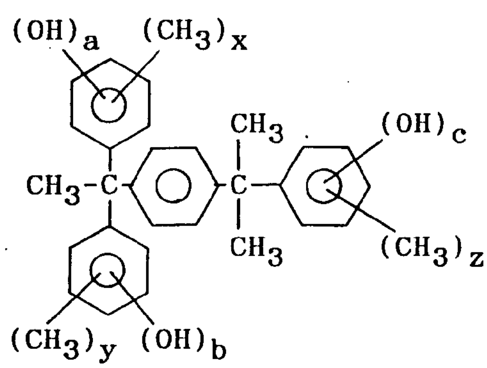

,

wherein each of a, b and c is independently an integer of 0 to 3 (provided that all of a, b and c cannot be zero), and each of x, y and z is independently an integer of 0 to 3 (provided that none of (a + x), (b + y) and (c + z) exceed four),

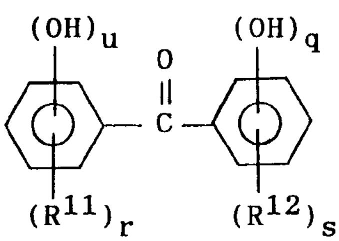

wherein each of $R^{11}$ and $R^{12}$ is independently a hydrogen atom, an alkyl group having 1 to 3 carbon atoms or an alkoxy group having 1 to 3 carbon atoms and each of u, q, r and s is independently an integer of 0 to 5, provided that u + q equals 2 to 6 and that r + s equals 0 to 5,
or hydroxyflavan compounds,
and 1,2-naphthoquinonediazide-4 or 5-sulfonate chloride. The 1,2-quinonediazide compound particularly preferably includes the following compounds:

1,2-naphthoquinonediazide-4-sulfonates and 1,2-naphthoquinonediazide-5-sulfonates such as 1,1-bis (2-hydroxyphenyl)methane, 1-(2-hydroxyphenyl)-1-(4-hydroxyphenyl)methane, 1,1-bis(4-hydroxyphenyl)methane, 1,1-bis(4-hydroxyphenyl)ethane, 2,2-bis(4-hydroxyphenyl)propane, 1,1,1-tris(2-hydroxyphenyl)methane, 1,1-bis(2-hydroxyphenyl)-1-(4-hydroxyphenyl)methane, 1,1-bis(4-hydroxyphenyl)-1-(2-hydroxyphenyl)methane, 1,1,1-tris(4-hydroxyphenyl)methane, 1,1,1-tris(2-hydroxyphenyl)ethane, 1,1-bis(2-hydroxyphenyl)-1-(4-hydroxyphenyl) ethane, 1,1-bis(4-hydroxyphenyl)-1-(2-hydroxyphenyl)ethane, 1,1,1-tris(4-hydroxyphenyl)ethane, 1,1-bis(4-hydroxyphenyl)-1- [4-{1-(4-hydroxyphenyl)-1-methylethyl}phenyl]ethane, 2,3,4-trihydroxybenzophenone, 2,3,4,4'-tetrahydroxybenzophenone, 3'-methoxy-2,3,4,4'-tetrahydroxybenzophenone and 2,4,4-trimethyl-2',4',7-trihydroxy-2-phenylflavan.

The esterification ratio of the hydroxy compound is preferably 40 to 100 %. The esterification ratio is calculated on the basis of the following equation.

$$\text{Esterification ratio (\%)} = \frac{\text{Number of 1,2-quinonediazidesulfonyl groups}}{\text{Number of hydroxy groups of hydroxy compound before esterification}} \times 100$$

The amount of the 1,2-quinonediazide compound per 100 parts by weight of the alkali-soluble resin is preferably 5 to 75 parts by weight, more preferably 10 to 50 parts by weight. When the amount of the 1,2-quinonediazide compound is too small, it is difficult to obtain a difference in solubility to a developer solution composed of an alkaline aqueous solution between a portion exposed to radiation and a portion not exposed to irradiation, and it becomes hence difficult to form a pattern. When the above amount is too large, the incorporated 1,2-quinonediazide compound cannot be wholly decomposed when the exposure is carried out for a short period of time, and it hence tends to be difficult to develop the composition with a developer solution composed of an alkaline aqueous solution.

The composition of the present invention may contain a solubility promoter for improving the sensitivity and developability.

The solubility promoter is selected from the compounds B described previously, and examples of the compounds B preferably include 1,1-bis(2-hydroxyphenyl)methane, 1-(2-hydroxyphenyl)-1-(4-hydroxyphenyl)methane, 1,1-bis(4-hydroxyphenyl)methane, 1,1-bis(4-hydroxyphenyl)ethane, 1,1-bis(4-hydroxyphenyl)ethane, 2,2-bis(4-hydroxyphenyl)propane, 1,1,1-tris(2-hydroxyphenyl)methane, 1,1-bis(2-hydroxyphenyl)-1-(4-hydroxyphenyl)methane, 1,1-bis(4-hydroxyphenyl)-1-(2-hydroxyphenyl)methane, 1,1,1-tris(4-hydroxyphenyl) methane, 1,1,1-tris(2-hydroxyphenyl)ethane, 1,1-bis(2-hydroxyphenyl)-1-(4-hydroxyphenyl)ethane, 1,1-bis(4-hydroxyphenyl)-1-(2-hydroxyphenyl)ethane, 1,1,1-tris(4-hydroxyphenyl)ethane, 1,1-bis(4-hydroxyphenyl)-1-[4-{1-(4-hydroxyphenyl)-1-methylethyl}phenyl]ethane, 1,1-bis(4-hydroxyphenyl)-1-phenylethane, 1,1-bis(2-hydroxyphenyl)-1-phenylethane, 1,1-bis(4-hydroxyphenyl)-1-phenylmethane and 1,1-bis(2-hydroxyphenyl)-1-phenylmethane.

When the alkali-soluble resin and the solubility promoter are used as a mixture, the amount of the alkali-soluble resin is preferably 60 to 100 parts by weight, more preferably 80 to 100 parts by weight, particularly preferably 85 to 99 parts by weight, and the amount of the solubility promoter is preferably 0 to 40 parts by weight, more preferably 0 to 20 parts by weight, particularly preferably 1 to 15 parts by weight, provided that the total amount of the alkali-soluble resin and the solubility promoter is 100 parts by weight. When the amount of the alkali-soluble resin is less than 60 parts by weight, the resultant composition shows poor heat resistance. When the amount of the solubility promoter exceeds 40 parts by weight, the resultant composition shows poor acid resistance.

The composition of the present invention may contain a sensitizer for improving the sensitivity to radiation. The sensitizer is selected, for example, from 2H-pyrido-(3,2-b)-1,4-oxazin-3(4H)-ones, 10H-pyrido-(3,2-b)-(1,4)-benzothiazines, urazols, hydantoins, barbituric acid and its derivatives, glycine anhydrides, 1-hydroxybenzotriazoles, alloxanic acid and its derivatives, and maleimides. The amount of the sensitizer per 100 parts by weight of the 1,2-quinonediazide compound is generally not more than 50 parts by weight.

The composition of the present invention may contain also a surfactant for improving coatability such as striation and developability of a portion exposed to radiation after a dry coating is formed. The surfactant is selected, for example, from polyoxyethylene lauryl ether, polyoxyethylene stearyl ether, polyoxyethylene oleyl ether, polyoxyethylene octylphenyl ether, polyoxyethylene nonylphenyl ether, polyethylene glycol dilaurate, polyethylene glycol distearate, F TOP EF301, EF303 and EF352 (supplied by New Akita Chemical Company), MEGAFAC F171, F172 and F173 (supplied by Dainippon Ink and Chemicals, Inc.), Fluorad FC430 and FC431

(supplied by Sumitomo-3M Limited), ASAHI GUARD AG710 and SURFLON S-382, SC-101, SC-102, SC-103, SC-104, SC-105 and SC-106 (supplied by Asahi Glass Co., Ltd.), Organosiloxane Polymer KP341 (supplied by Shin-Etsu Chemical Co., Ltd.), and acrylic acid or methacrylic acid (co)polymers such as POLYFLOW No. 75, No. 90 and No. 95 (supplied by Kyoeisha Chemical Co., Ltd.). The amount of the surfactant is generally not more than 2 % by weight on the basis of the solid content in the composition.

Further, for visualizing a portion exposed to radiation and decreasing an influence by halation during the exposure to radiation, the composition of the present invention may contain a dye such as 1,7-bis (3-methoxy-4-hydroxyphenyl)-1,6-heptadien-3,5-dione or 5-hydroxy-4-(4-methoxyphenylazo)-3-methyl-1-phenylpyrazole.

The composition of the present invention may further contain a storage stabilizer and an antifoamer as required.

As a method of applying the composition of the present invention onto a substrate, there can be mentioned a method in which predetermined amounts of the alkali-soluble resin, the 1,2-quinonediazide compound, the compound (I) and, optionally, other additives are dissolved in a solvent to prepare a solution having a solid content of 15 to 40 % by weight, and the solution is filtered and coated on a substrate by spin coating, flow coating or roll coating.

The solvent used for the above coating is selected, for example, from methylcellosolve, ethylcellosolve, methylcellosolve acetate, ethylcellosolve acetate, diethylene glycol monomethyl ether, diethylene glycol monoethyl ether, propylene glycol methyl ether acetate, propylene glycol ethyl ether acetate, propylene glycol propyl ether acetate, toluene, xylene, methyl ethyl ketone, cyclohexanone, methyl 2-hydroxypropionate, ethyl 2-hydroxypropionate, ethyl 2-hydroxy-2-methylpropionate, methyl 3-methoxypropionate, ethyl 3-methoxypropionate, methyl 3-ethoxypropionate, ethyl 3-ethoxypropionate, ethyl ethoxyacetate, ethyl oxyacetate, methyl 2-hydroxy-3-methylbutanoate, 3-methyl-3-methoxybutyl acetate, 3-methyl-3-methoxybutyl propionate, 3-methyl-3-methoxybutyl butanoate, ethyl acetate, butyl acetate, methyl pyruvate and ethyl pyruvate.

Further, there may be added a solvent having a high boiling point, such as benzyl ethyl ether, dihexyl ether, diethylene glycol monomethyl ether, diethylene glycol monoethyl ether, diethylene glycol monobutyl ether, acetonylacetone, isophorone, caproic acid, caprilic acid, 1-octanol, 1-nonanol, benzyl alcohol, benzyl acetate, ethyl benzoate, diethyl oxalate, diethyl maleate, γ-butyrolactone, ethylene carbonate, propylene carbonate, or phenylcellosolve acetate.

The developer solution for the composition of the present invention is selected, for example, from alkaline aqueous solutions in which there are dissolved sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, dimethylethanolamine, triethanolamine, tetramethylammonium hydroxide, tetraethylammonium hydroxide, choline, pyrrole, piperidine, 1,8-diazabicyclo-(5.4.0)-7-undecene, and 1,5-diazabicyclo-(4.3.0)-5-nonane. Further, the developer solution may contain a proper amount of a water-soluble organic solvent selected from alcohols such as methanol and ethanol and surfactants.

For further improving the effect of the composition of the present invention when used as a positive photoresist, the composition of the present invention may be coated on a substrate, and the coating is pre-baked, exposed to radiation, heated at 70 to 140°C and then developed, or is exposed to radiation while it is heated at 70 to 140°C.

Generally, after development with the alkaline aqueous solution, the resist film is rinsed with water and then dried.

The radiation-sensitive resin composition of the present invention exhibits high sensitivity, high resolution and high heat resistance, and it is suitable as a positive resist having excellent adhesion to a substrate and excellent acid resistance.

The present invention will be explained in more detail by reference to Synthesis Examples and working Examples, although these Examples shall not limit the present invention.

In Examples, Mw and resist performance were evaluated by the following methods.

Mw: Measured by a gel permeation chromatography using GPC columns (2 G2000$H_6$ columns, 1 G3000$H_6$ column and 1 G4000$H_6$ column, supplied by Tosoh Corp.) under analysis conditions where the flow rate was 1.5 ml/minute, the solvent for elution was tetrahydrofuran and the column temperature was 40°C while monodisperse polystyrene was used as a reference.

Sensitivity: A resist pattern was formed on a silicon wafer by carrying out exposure with a reduction projection aligner (NSR1505G4D, lens opening coefficient: 0.54, g-ray aligner, supplied by Nikon Corp.), and developing the exposed sample with an aqueous solution containing 2.4 % by weight of tetramethylammonium hydroxide at 25°C for 60 seconds, followed by rinsing with water and drying, to determine a time for exposure required for forming a 2.0 μm line and space pattern in a line width of 1:1 (to be referred to as "optimum exposure time" hereinafter).

Resolution: A minimum resist pattern resolved for an optimum exposure time was measured for a dimension.

Heat resistance: A silicon wafer on which a resist pattern had been formed was heated on a hot plate while the temperature was changed from 120°C to 150°C at intervals of 5°C to determine a maximum temperature at which the resist pattern was maintained.

Adhesion: A resist pattern was formed on an ITO substrate by carrying out exposure with an ultraviolet aligner (PLA501F, supplied by Canon Inc.), developing the exposed sample with an aqueous solution containing 2.4 % by weight of tetramethylammonium hydroxide at 25°C for 60 seconds, rinsing it with water and drying it. The developed resist film was post-baked on a hot plate at 120°C for etching. After the etching, a case where a 5 μm resist pattern remained without being peeled off was taken as ○ in adhesion, a case where a 5 μm resist pattern was peeled off but a 10 μm resist pattern remained without being peeled off was taken as Δ in adhesion, and a case where both the 5 μm and 10 μm resist patterns were peeled off was taken as X in adhesion.

Acid resistance: A case where an etched resist film showed no failure was taken as excellent in acid resistance, and a case where an etched resist film underwent cracking was taken as poor.

Synthesis Example 1

A separable flask equipped with a stirrer, a cooling tube and a thermometer was charged with 123. 2 g (1.142 mol) of m-cresol, 52.2 g (0.0427 mol) of 3,5-xylenol, 130.3 g (1.605 mol of formaldehyde) of an aqueous solution containing 37 % by weight of formaldehyde (to be referred to as "formalin" hereinafter) and 0.731 (0.00580 mol) of oxalic acid-dihydrate, and the separable flask was immersed in an oil bath. While the internal temperature was maintained at 100°C and the contents were stirred, polycondensation was carried out for 40 minutes. Then, 27.9 g (0.285 mol) of m-cresol and 13.1 g (0.107 mol) of 3,5-xylenol were added, and polycondensation was further carried out for 100 minutes to synthesize a resin. After the reaction, the oil bath temperature was increased up to 180°C, and the pressure in the reactor was simultaneously reduced to 30 to 40 mm Hg to remove water, oxalic acid, formaldehyde, m-cresol, 3,5-xylenol, etc. Then, the temperature of the molten resin was decreased to room temperature to recover the resin. The resin was dissolved in ethylcellosolve acetate to form a resin solution having a solid content of 20 % by weight. And, methanol in an amount twice as much as that of the resin solution and water in an amount equal to that of the resin solution were added, and the resultant mixture was stirred and allowed to stand. After the mixture separated into two layers, a resin solution (lower layer) was withdrawn, concentrated, dehydrated and dried to recover a resin A (to be referred to as "Resin A(1)" hereinafter).

Synthesis Example 2

The same separable flask as that used in Synthesis Example 1 was charged with 89.1 g (0.824 mol) of m-cresol, 55.7 g (0.515 mol) of p-cresol, 125.3 g of formalin (1.544 mol of formaldehyde) and 1.558 g (0.0120 mol) of oxalic acid·dihydrate, and the separable flask was immersed in an oil bath. While the internal temperature was maintained at 100°C and the contents were stirred, polycondensation was carried out for 35 minutes. Then, 22.3 g (0.206 mol) of m-cresol and 23.4 g (0.172 mol) of 2,3,5-trimethylphenol were added, and polycondensation was further carried out for 80 minutes to synthesize a resin. After the reaction, the oil bath temperature was increased up to 180°C, and the pressure in the reactor was simultaneously reduced to 30 to 40 mm Hg to remove water, oxalic acid, formaldehyde, m-cresol, p-cresol, 2,3,5-trimethylphenol, etc. Then, resultant resin was treated in the same manner as in Synthesis Example 1 to recover a resin A (to be referred to as "Resin A(2)" hereinafter).

Synthesis Example 3

The same separable flask as that used in Synthesis Example 1 was charged with 124.4 g (1.140 mol) of m-cresol, 19.3 g (0.178 mol) of p-cresol, 21.7 g (0.178 mol) of 3,4-xylenol, 137.3 g of formalin (1.693 mol of formaldehyde) and 0.731 g (0.00580 mol) of oxalic acid dihydrate, and the separable flask was immersed in an oil bath. While the internal temperature was maintained at 100°C and the contents were stirred, polycondensation was carried out for 50 minutes. Then, 31.1 g (0.285 mol) of m-cresol was added, and polycondensation was further carried out for 100 minutes to synthesize a resin. After the reaction, the oil bath temperature was increased up to 180°C, and the pressure in the reactor was simultaneously reduced to 30 to 40 mm Hg to remove water, oxalic acid, formaldehyde, m-cresol, p-cresol, 3,4-xylenol, etc. Then, resultant resin was treated in the same manner as in Synthesis Example 1 to recover a resin A (to be referred to as "Resin A(3)" hereinafter).

Synthesis Example 4

The same separable flask as that used in Synthesis Example 1 was charged with 155.7 g (1.427 mol) of m-cresol, 137.3 g of formalin (1.693 mol of formaldehyde) and 0.233 g (0.00185 mol) of oxalic acid-dihydrate, and the separable flask was immersed in an oil bath. While the internal temperature was maintained at 100°C and the contents were stirred, polycondensation was carried out for 35 minutes. Then, 38.9 g (0.357 mol) of m-cresol was added, and polycondensation was further carried out for 70 minutes to synthesize a resin. After the reaction, the oil bath temperature was increased up to 180°C, and the pressure in the reactor was simultaneously reduced to 30 to 40 mm Hg to remove water, oxalic acid, formaldehyde, m-cresol, etc. Then, resultant resin was treated in the same manner as in Synthesis Example 1 to recover a resin A (to be referred to as "Resin A(4)" hereinafter).

Synthesis Example 5

The same separable flask as that used in Synthesis Example 1 was charged with 155.0 g (1.421 mol) of m-cresol, 8.1 g (0.074 mol) of p-cresol, 150.0 g of formalin (1.849 mol of formaldehyde) and 0.233 g (0.00185 mol) of oxalic acid·dihydrate, and the separable flask was immersed in an oil bath. While the internal temperature was maintained at 100°C and the contents were stirred, polycondensation was carried out for 60 minutes. Then, 38.8 g (0.355 mol) of m-cresol was added, and polycondensation was further carried out for 90 minutes to synthesize a resin. After the reaction, the oil bath temperature was increased up to 180°C, and the pressure in the reactor was simultaneously reduced to 30 to 40 mm Hg to remove water, oxalic acid, formaldehyde, m-cresol, p-cresol, etc. Then, resultant resin was treated in the same manner as in Synthesis Example 1 to recover a resin A (to be referred to as "Resin A(5)" hereinafter).

Example 1

| | |
|---|---|
| Resin A(1) | 90 g |
| Compound B(1) shown in Table 1 | 10 g |
| 1,2-Quinonediazide compound (1) shown in Table 1 | 25 g |
| Compound (I)(1) shown in Table 1 | 10 g |
| Ethyl 2-hydroxypropionate (to be referred to as "EL" hereinafter) | 334 g |

The above components were mixed to form a solution, and the solution was filtered with a membrane filter having openings measuring 0.1 μm in diameter to obtain a solution of a composition according to the present invention. The solution was applied to a silicon wafer coated with an oxide film, and pre-baked on a hot plate at 90°C for 2 minutes to form a resist film having a thickness of 1.2 μm. The resist film was exposed and developed to form a resist pattern. This resist pattern was observed and measured through a scanning electron microscope. A resist pattern was formed on each of seven silicon wafers in the same manner, and these resist patterns were observed on their heat resistance.

Further, the other resist patterns formed in the same manner as above were etched in a 30 % hydrochloric acid/5 % ferric chloride aqueous solution at 45°C for 180 seconds to observe their adhesion and acid resistance. Table 1 shows the results.

Example 2

| | |
|---|---|
| Resin (A)2 | 95 g |
| Compound B(2) shown in Table 1 | 5 g |
| 1,2-Quinonediazide compound (1) shown in Table 1 | 30 g |
| Compound (I)(2) shown in Table 1 | 15 g |
| Methyl 3-methoxypropionate (to be referred to as "MMP" hereinafter) | 334 g |

The above components were mixed to form a solution, and the solution was filtered with a membrane filter having openings measuring 0.1 μm in diameter to obtain a solution of a composition according to the present invention. Resist films were prepared from the so-obtained solution in the same manner as in Example 1 and tested on their resist performance in the same manner as in Example 1. Table 1 shows the results.

Example 3

| | |
|---|---|
| Resin A(3) | 95 g |
| Compound B(3) shown in Table 1 | 5 g |
| 1,2-Quinonidiazide compound (2) shown in Table 1 | 30 g |
| Compound (I)(1) shown in Table 1 | 5 g |
| EL | 117 g |
| MMP | 117 g |

The above components were mixed to form a solution, and the solution was filtered with a membrane filter having openings measuring 0.1 μm in diameter to obtain a solution of a composition according to the present invention. Resist films were prepared from the so-obtained solution in the same manner as in Example 1 and tested on their resist performance in the same manner as in Example 1. Table 1 shows the results.

Example 4

| | |
|---|---|
| Resin A(2) | 100 g |
| 1,2-Quinonediazide compound (3) shown in Table 1 | 20 g |
| Compound (I)(3) shown in Table 1 | 10 g |
| Ethylcellosolve acetate (to be referred to as "ECA" hereinafter) | 334 g |

The above components were mixed to form a solution, and the solution was filtered with a membrane filter having openings measuring 0.1 μm in diameter to obtain a solution of a composition according to the present invention. Resist films were prepared from the so-obtained solution in the same manner as in Example 1 and tested on their resist performance in the same manner as in Example 1. Table 1 shows the results.

Example 5

| | |
|---|---|
| Resin A(4) | 95 g |
| Compound B(1) shown in Table 1 | 5 g |
| 1,2-Quinonediazide compound (2) shown in Table 1 | 30 g |
| Compound (I)(1) shown in Table 1 | 5 g |
| EL | 334 g |

The above components were mixed to form a solution, and the solution was filtered with a membrane filter having openings measuring 0.1 μm in diameter to obtain a solution of a composition according to the present invention. Resist films were prepared from the so-obtained solution in the same manner as in Example 1 and tested on their resist performance in the same manner as in Example 1 except that the etching was carried out in a 3 % hydrofluoric acid/65 % nitric acid aqueous solution at 25°C for 60 seconds. Table 1 shows the results.

Example 6

| | |
|---|---|
| Resin A(3) | 100 g |
| 1,2-Quinonediazide compound (1) shown in Table 1 | 20 g |
| Compound (I)(2) shown in Table 1 | 1 g |
| MMP | 334 g |

The above components were mixed to form a solution, and the solution was filtered with a membrane filter having openings measuring 0.1 μm in diameter to obtain a solution of a composition according to the present invention. Resist films were prepared from the so-obtained solution in the same manner as in Example 1 and tested on their resist performance in the same manner as in Example 5. Table 1 shows the results.

Comparative Example 1

| | |
|---|---|
| Resin A(1) | 90 g |
| Compound B(1) shown in Table 1 | 10 g |
| 1,2-Quinonediazide compound (1) shown in Table 1 | 25 g |
| EL | 334 g |

The above components were mixed to form a solution, and the solution was filtered with a membrane filter having openings measuring 0.1 μm in diameter to obtain a solution of a composition. Resist films were prepared from the so-obtained solution in the same manner as in Example 1 and tested on their resist performance in the same manner as in Example 1. Table 1 shows the results.

Table 1 Test results on Resist Performance

| | | Example 1 | Example 2 | Example 3 | Example 4 |
|---|---|---|---|---|---|
| Resin A<br>Kind [Mw]<br>[Mw/Mn]<br>Amount (parts by weight) | | A(1)[9200]<br>[8.1]<br>90 | A(2)[12000]<br>[9.5]<br>95 | A(3)[10400]<br>[10.2]<br>95 | A(2)[12000]<br>[9.5]<br>100 |
| Compound B<br>Kind<br>Amount (parts by weight) | | B(1)<br>10 | B(2)<br>5 | B(3)<br>5 | - |
| 1,2-Quinone-diazide compound<br>Kind<br>Amount (parts by weight) | | Q(1)<br>25 | Q(2)<br>30 | Q(2)<br>30 | Q(3)<br>20 |
| Compound (I)<br>Kind<br>Amount (parts by weight) | | I(1)<br>10 | I(2)<br>15 | I(1)<br>5 | I(3)<br>10 |
| Solvent<br>Kind<br>Amount (parts by weight) | | EL<br>334 | MMP<br>334 | EL/MMP<br>117/117 | ECA<br>334 |
| Test results on resist performance | Sensitivity (msec) | 102 | 92 | 90 | 131 |
| | Resolution (μm) | 0.60 | 0.60 | 0.65 | 0.55 |
| | Heat resistance (°C) | 130 | 130 | 130 | 135 |
| | Adhesion | ○ | ○ | ○ | ○ |
| | Acid resistance | Excellent | Excellent | Excellent | Excellent |

- to be continued -

Table 1 (continued)

| | | Example 5 | Example 6 | Comparative Example 1 |
|---|---|---|---|---|
| Resin A<br>Kind [Mw]<br>[Mw/Mn]<br>Amount (parts by weight) | | A(4)[13500]<br>[11.6]<br>95 | A(3)[10400]<br>[10.2]<br>100 | A(1)<br><br>90 |
| Compound B<br>Kind<br>Amount (parts by weight) | | B(1)<br>5 | - | B(1)<br>10 |
| 1,2-Quinone-diazide compound<br>Kind<br>Amount (parts by weight) | | Q(2)<br>30 | Q(1)<br>20 | Q(1)<br>25 |
| Compound (I)<br>Kind<br>Amount (parts by weight) | | I(1)<br>5 | I(2)<br>1 | - |
| Solvent<br>Kind<br>Amount (parts by weight) | | EL<br>334 | MMP<br>334 | EL<br>334 |
| Test resultd on resist performance | Sensitivity (msec) | 85 | 99 | 125 |
| | Resolution (μm) | 0.65 | 0.65 | 0.60 |
| | Heat resistance (°C) | 145 | 130 | 125 |
| | Adhesion | ○ | ○ | X |
| | Acid resistance | Excellent | Excellent | Excellent |

In Table 1:

EL = ethyl 2-hydroxypropionate  
MMP = methyl 3-methoxypropionate  
ECA = ethylcellosolve acetate  
Compound B(1) = 1,1-bis(4-hydroxyphenyl)-1-phenylethane  
Compound B(2) = 1,1-bis(4-hydroxyphenyl)-1[4-{1-(hydroxyphenyl)-1-methylethyl}phenyl]ethane  
Compound B(3) = 1,1,1-tris(4-hydroxyphenyl)ethane  
1,2-Quinonediazide compound Q(1) = condensate from 1,1-bis(2-hydroxyphenyl)ethane (1 mol) and

1,2-naphthoquinonediazide-5-sulfonate chloride (2.0 mol)

1,2-Quinonediazide compound Q(2) = condensate from 2,3,4,4'-tetrahydroxybenzophenone (1 mol) and 1,2-naphthoquinonediazide-5-sulfonate chloride (3.3 mol)

1,2-Quinonediazide compound Q(3) = condensate from 1,1-bis(4-hydroxyphenyl)-1-[4-{1-(4-hydroxyphenyl)-1-methylethyl}phenyl]ethane (1 mol) and 1,2-naphthoquinonediazide-5-sulfonate chloride (2.0 mol).

Compound I(1) = 2-(3,4-epoxycyclohexyl)-ethyltrimethoxysilane

Compound I(2) = 2-(3,4-epoxycyclohexyl)-ethyltriethoxysilane

Compound I(3) = 3-(3,4-epoxycyclohexyl)-propyltrimethoxysilane

## Claims

1. A radiation-sensitive resin composition containing an alkali-soluble resin, a 1,2-quinonediazide compound and a compound of the formula (1),

$$X\text{-}C_nH_{2n}\text{-}Si(OR)_3 \quad (1)$$

wherein each of Rs is independently an alkyl group, n is an integer of 1 to 5, and X is

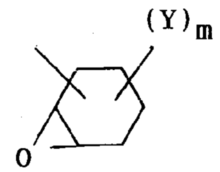

,

in which Y or each of Ys is independently an alkyl or alkoxy group and m is an integer of 0 to 9.

2. The composition of Claim 1, wherein the alkali-soluble resin is an alkali-soluble novolak resin.

3. The composition of claim 1, wherein the alkali-soluble resin is a polycondensation product of a phenol with an aldehyde, said phenol being at least one member selected from the group consisting of m-cresol, p-cresol and a phenol A of the following formula (2)

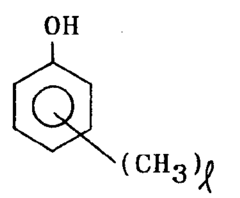

(2)

wherein $\ell$ is 2 or 3,

and the molar ratio of m-cresol/p-cresol/the phenol A being 60-100/0-30/0-40.

4. The composition of Claim 1, wherein the 1,2-quinonediazide compound is an ester obtained from either a hydroxy compound having at least two benzene skeletons having a hydroxyl group or a hydroxyflavan compound, and either 1,2-naphthoquinonediazide-4-sulfonate chloride or 1,2-naphthoquinonediazide-5-sulfonate chloride.

5. The composition of Claim 1, wherein the 1,2-quinonediazide compound is contained in an amount of 5 to 75 parts by weight per 100 parts by weight of the alkali-soluble resin.

6. The composition of claim 1, wherein in the formula (1), each of Ys is independently an alkyl group having 1 to 3 carbon atoms or an alkoxy group having 1 to 3 carbon atoms, n is an integer of 1 to 3 and m is an integer of 0 to 2.

7. The composition of claim 1, wherein the compound of the formula (1) is selected from the group consisting of 2-(3,4-epoxycyclohexyl)ethyltrimethoxysilane, 2-(3,4-epoxycyclohexyl)ethyltriethoxysilane, 2-(3,4-epoxycyclohexyl)ethyltripropoxysilane, 2-(3,4-epoxycyclohexyl)ethyldimethoxymonoethoxysilane, 2-(3,4-epoxycyclohexyl)ethylmonomethoxydiethoxysilane, (3,4-epoxycyclohexyl)methyltrimethoxysilane,

3-(3,4-epoxycyclohexyl)propyltrimethoxysilane, 2-(2,3-epoxycyclohexyl)ethyltrimethoxysilane, 2-(1,2-epoxycyclohexyl)ethyltrimethoxysilane, and 2-(2,3-epoxycyclohexyl)ethyltriethoxysilane.

**8.** The composition of Claim 5, wherein the compound of the formula (1) is contained in an amount of 0.1 to 25 parts by weight per 100 parts by weight of the alkali-soluble resin.

**9.** The composition of Claim 1, wherein the amount of the alkali-soluble resin is 85 to 99 parts by weight and the amount of the solubility promoter is 1 to 15 parts by weight, based on 100 parts by weight of the total amount of the alkali-soluble resin and the solubility promoter.

European Patent Office

# EUROPEAN SEARCH REPORT

Application Number
EP 93 30 0647

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | DE-A-2 461 515 (FUJI)<br>* page 9, line 8 - line 28 *<br>* page 19, line 3; claims 1,13 *<br>--- | 1-9 | G03F7/075 |
| A | PATENT ABSTRACTS OF JAPAN<br>vol. 13, no. 152 (P-856)(3500) 13 April 1989<br>& JP-A-63 313 149 ( NIPPON ZEON ) 21 December 1988<br>* abstract *<br>----- | 1-9 | |
| | | | TECHNICAL FIELDS SEARCHED (Int. Cl.5 ) |
| | | | G03F |

The present search report has been drawn up for all claims

| Place of search | Date of completion of the search | Examiner |
|---|---|---|
| THE HAGUE | 13 APRIL 1993 | MAGRIZOS S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)